# EUROPEAN PATENT APPLICATION

(11) **EP 4 845 320 A1**
(43) Date of publication of application: **25.11.2026**
(21) Application number: 25178156.3
(22) Date of filing: 22.05.2025
(51) Int. Cl.: H05K 7/14

(54) **RACK FOR A POWER CONVERTER SYSTEM, RACK SYSTEM AND METHOD**

(71) Applicant: Hitachi Energy Ltd, 8050 Zürich (CH)
(72) Inventor: Lutz, Pascal, 5432 Neuenhof (CH); Schwarzmaier, Thomas, 5430 Wettingen (CH); Heinig, Stefanie, 4053 Basel (CH)
(74) Representative: Epping - Hermann - Fischer

(57) **Abstract**

A rack for a power converter system (200) comprises:
- a frame (102) for holding a plurality of converter modules (101),
- a displacement device (110) for moving the rack (100) relative to a floor (300) on which the rack (100) is supported.

## Description

The present disclosure relates to a rack for a power converter system, in particular a rack for mounting power electronics building blocks. The disclosure further relates to a rack system for a power converter system. The disclosure further relates to a method for operating a rack system, in particular a rack system as disclosed herein.

A power converter may comprise a plurality of power electronics building block, in the following also referred to as PEBB. The PEBBs may be replaced for maintenance and/or if they are malfunctioning.

It is desirable to provide a rack for a power converter system that can be operated reliably. It is desirable to provide a rack system that can be operated reliably. It is desirable to provide a reliable method for operating a rack system.

Embodiments of the disclosure relate to a rack for a power converter system. Embodiments of the disclosure relate to a rack system for a power converter system. Embodiments of the disclosure relate a method for operating a rack system of a power converter system.

The rack comprises a frame for holding a plurality of converter modules. For example, the converter modules are PEBBs. For example, the PEBBs are each a functional unit that can be configured to perform specific power conversion, control or regulation tasks within the power converter system. For example, the PEBBs comprise each capacitors and/or power semiconductors and/or other elements. For example, the PEBBs are configured to store electrical energy. For example, the power converter system is a multi-level converter or a multi-level inverter or comprises a multi-level converter or a multi-level inverter or is part of a multi-level converter or a multi-level inverter.

The rack comprises a displacement device for moving the rack relative to a floor on which the rack is supported. For example, the displacement device comprises wheels. For example, the wheels are fixed to frame braces of the frame and/or to frame feet of the frame and/or to a base plate of the frame and/or to insulators of the frame. The displacement device is an integral part of the rack. It is not only used during transport and installation of the rack but remains part of the rack during operation. The displacement device enables low-friction movement of the rack relative to the floor on which the rack stands. For example, the rack is movable to create more space for maintenance. For example, the movement creates enough space in front of the rack to remove the converter module from the rack or to insert a converter module into the rack.

It is possible to place the rack in a first state, for example a normal operating state, at a first location where there is not enough space in front of the rack, to remove a converter module from the rack or to insert a converter module into the rack. It is possible to move the rack relative to the floor in a second state, for example a maintenance state, and to position it at a different location than in the first state, such that there is enough space in front of the rack to remove a converter module from the rack or to insert a converter module into the rack.

According to some embodiments, the displacement device comprises a first state in which the movement relative to the floor is blocked and a second state in which the movement relative to the floor is enabled. For example, the rack is fixed relative to the floor in the first state and a movement is blocked. In the second state, the movement of the rack relative to the floor is enabled.

According to some embodiments, the wheels are configured to run on rails. For example, the rails are arranged on the floor. The movement of the rack with the wheels on the rails enables a secure and reliable movement, in particular even with heavy racks.

According to some embodiments, the frame is configured so that the converter modules are insertable and removable along a first direction, wherein the displacement device is configured for moving the rack along the first direction. This allows space to be created by moving the rack to insert and remove the converter module. Also, the rack is movable into a space-saving position when no insertion or removal of the converter module is intended.

The rack system comprises a first rack as disclosed herein. The rack system comprises a second rack as disclosed herein. The first rack and the second rack are arranged next to each other along a first direction and are movable relative to each other along the first direction.

For example, the first rack and the second rack are positioned close to each other in a first state, for example a normal operating state. For example, the first rack and the second rack are positioned so close to each other that no insertion or removal of the converter module is possible. There is not enough space between the racks to insert and remove the converter module between the racks.

For example, the first rack and the second rack are arranged further away from each other along the first directions in a second state, e.g. a maintenance state, than in the first state. This makes insertion or removal of the converter module possible.

According to some embodiments, in the first state, a distance between the first rack and the second rack is less than an extension of the converter module along the first direction. In the second state the distance is greater than the extension. This allows for a space-saving arrangement of the racks in the first state and a reliable insertion or removal of the converter module in the second state.

According to some embodiments, the rack system comprises rails. For example, the rails are attached to the floor. The frames are each movably supported on the rails for a movement along the rails. The rails enable a secure and reliable movement of the racks with respect to each other, in particular even with heavy racks.

According to some embodiments, the rack system comprises an electricity supply, wherein the first rack and the second rack are each releasably connected to the electricity supply. For example, the first rack and the second rack are each connected to the electricity supply in the first state. For example, the first rack and the second rack are each disconnected from the electricity supply in the second state. This enables a power supply in the first state and a movement of the racks relative to each other in the second state without disturbance from the electricity supply.

According to some embodiments, the electricity supply comprising a flexible cable connection to the first rack and the second rack, wherein the flexible cable connection is configured to enable the movement of the first rack and the second rack relative to each other.

It is possible, that the first rack and the second rack are each releasably connected to the electricity supply via the flexible cable.

It is also possible, that the first rack and the second rack are each firmly connected to the electricity supply via the flexible cable. In this case, the flexible cable is long and flexible enough to allow the movement between the first state and the second state.

According to some embodiments, the rack system comprises a coolant supply, wherein the first rack and the second rack are each releasably connected to the coolant supply. For example, the first rack and the second rack are each connected to the coolant supply in the first state. For example, the first rack and the second rack are each disconnected from the coolant supply in the second state. This enables a coolant supply in the first state and a movement of the racks relative to each other in the second state without disturbance from the coolant supply. For example, the coolant comprises water or any other cooling liquid.

According to some embodiments, the coolant supply comprises a flexible hose connection to the first rack and the second rack, wherein the flexible hose connection is configured to enable the movement of the first rack and the second rack relative to each other.

It is possible, that the first rack and the second rack are each releasably connected to the coolant supply via the flexible hose.

It is also possible, that the first rack and the second rack are each firmly connected to the coolant supply via the flexible hose. In this case, the flexible hose is long and flexible enough to allow the movement between the first state and the second state.

The method for operating a rack system of a power converter system comprises:
- moving a rack of the power converter system relative to a floor along a first direction from a first state to a second state,
- inserting and/or removing a converter module along the first direction into and/or out of the rack,
- moving the rack along the first direction from the second state to the first state.

For example, the rack is moved to create more space for maintenance. For example, the movement creates enough space in front of the rack for the removing the converter module from the rack and/or for the inserting the converter module into the rack. Also, the rack is moved into a space-saving position when no insertion or removal of the converter module is intended, for example after inserting and/or removing the converter module along the first direction into and/or out of the rack.

According to some embodiments, the method comprises:
- blocking a movement of the rack in the first state,
- releasing the blocking before moving the rack to the second state. For example, this enables a secure operation in the first state and avoidance of an unwanted movement.

According to some embodiments, the method comprises moving the first rack and the second rack relative to each other along the first direction from the first state to the second state.

The method for operating a rack system of a power converter system described herein is particularly suitable for the rack and the rack system described herein. Features and advantages described in connection with the rack and the rack system can therefore be used for the method and vice versa.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
Figure 1 is a schematic view of a rack with converter modules according to an embodiment,
Figures 2 and 3 are each a schematic view of a rack system according to embodiments,
Figure 4 is a schematic view of a rack system according to an embodiment, and
Figure 5 is a flow chart of a method for moving a rack according to an embodiment.

While the disclosure is amenable to various modifications and alternative forms, specifics thereof have been shown by way of example in the figures and will be described in detail. It should be understood, however, that the intention is not to limit the disclosure to the particular embodiments described. On the contrary, the intention is to cover all modifications, equivalents, and alternatives falling within the scope of the disclosure defined by the appended claims.

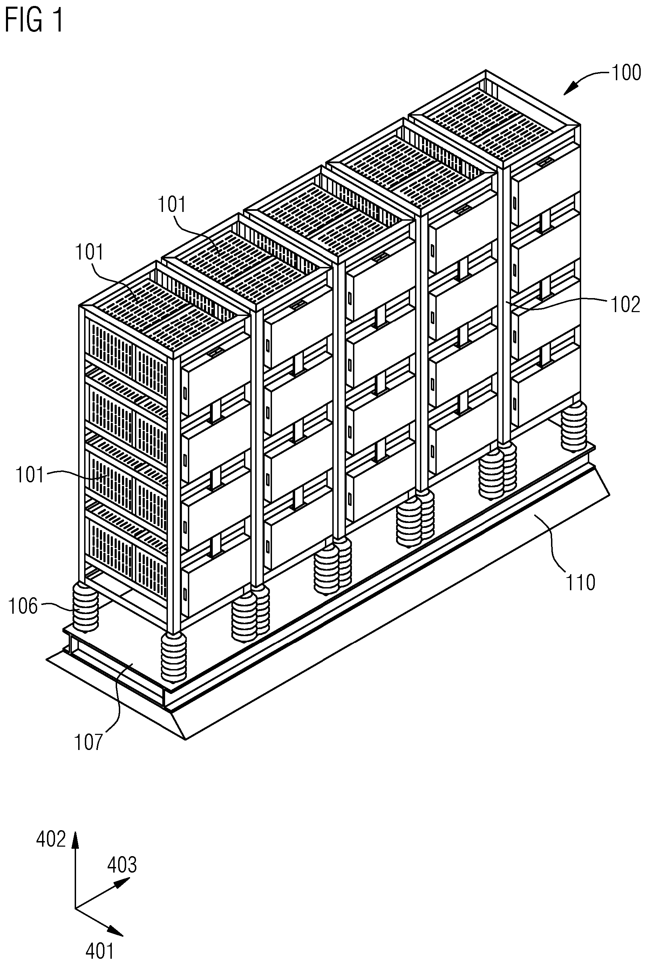

Figure 1 schematically shows a rack 100. The rack 100 comprises a frame 102 that supports and stores a plurality of converter modules 101. For example, the converter modules 101 are PEBBs.

The rack 100 provides a mounting slot for each of the converter modules 101. In particular, the frame 102 provides a mounting slot for each of the converter modules 101. The rack 100 with the frame 102 and the installed converter module 101 may be referred to as phase leg.

The converter modules 101 are mounted to the frame 100 by being pushed into the mounting slot in a first direction 401. The converter modules 101 are mounted in the frame 102 above each other in a second direction 402. The converter modules 101 are mounted in the frame 102 next to each other in a third direction 403. For example, the first direction 401, the second direction 402 and the third direction are perpendicular to each other. The shown number and arrangement of the converter modules 101 are only exemplary, other numbers and patterns are possible.

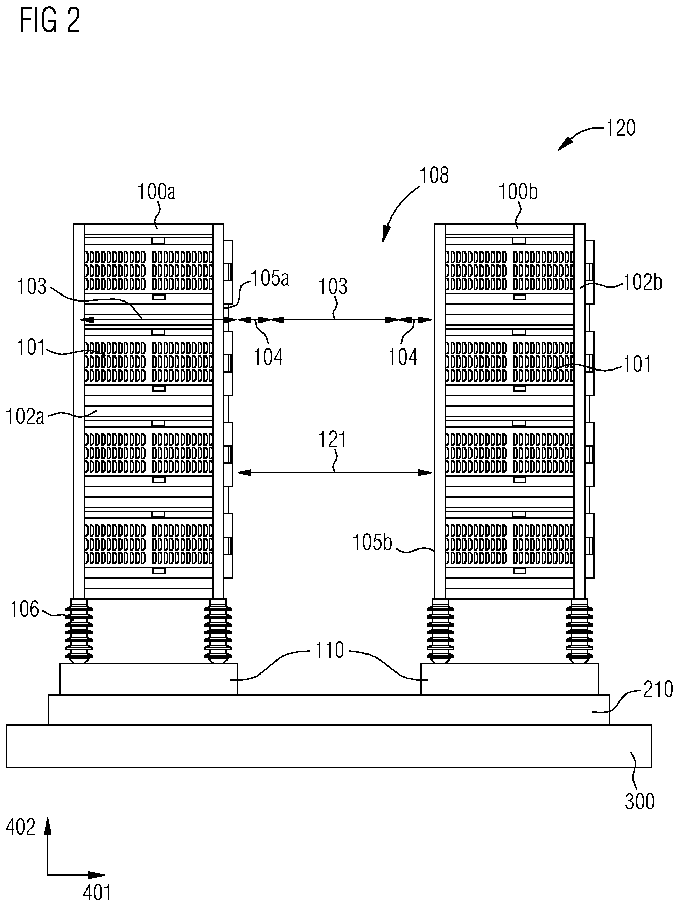

The frame 101 is supported on a floor 300 (Figure 2, for example) via frame feet 106 and a base plate 107. The frame feet 106 provide electrical insulation, for example. For example, the base plate 107 is longer along the third direction 403 than along the first direction 401 and along the second direction 402. The base plate 107 provides a common base for the frames 102 that are arranged on it. It is possible to omit the base plate 107.

A displacement device 110 is arranged below the frame 102. The displacement device 110 is arranged between the frame 102 and the floor 300. The frame 102 is supported on the floor 300 via the displacement device 110. For example, the displacement device 110 is attached to the base plate 107. For example, the displacement device 110 is attached to insulators at the bottom side of the frame 101, for example to the electrically insulating frame feet 106.

The displacement device 110 is configured for providing a movement of the rack 100 relative to the ground 300. In particular, the displacement device 110 is configured to provide a movement of the rack 100 along the first direction 401. In particular, the displacement device 110 only allows a movement along the first direction 401 and movement along the second direction 402 and movement along the third direction 403 are blocked.

The displacement device 110 comprises at least one of wheels, glides, rails, runners or other elements that enable low-friction movement. For example, the displacement device 110 is mounted to the frame 102 not shiftable. In the case of wheels, these can of course be rotated relative to the frame 102.

The displacement device 110 allows the frame 102 to be moved in a ready-to-use state. For example, in a first state, the frame 102 is arranged in a first position during an intended operation of the converter modules 101. In a second state, in which, for example, maintenance is carried out and/or one converter module 101 is or more of the converter modules 101 are replaced, the frame 102 is arranged in a second position. The first position and the second position are offset from each other along the first direction 401.

Figure 2 schematically shows a rack system 120. The rack system 120 comprises two racks 100a, 100b. This number is only an example, more than two racks 100 can also be provided.

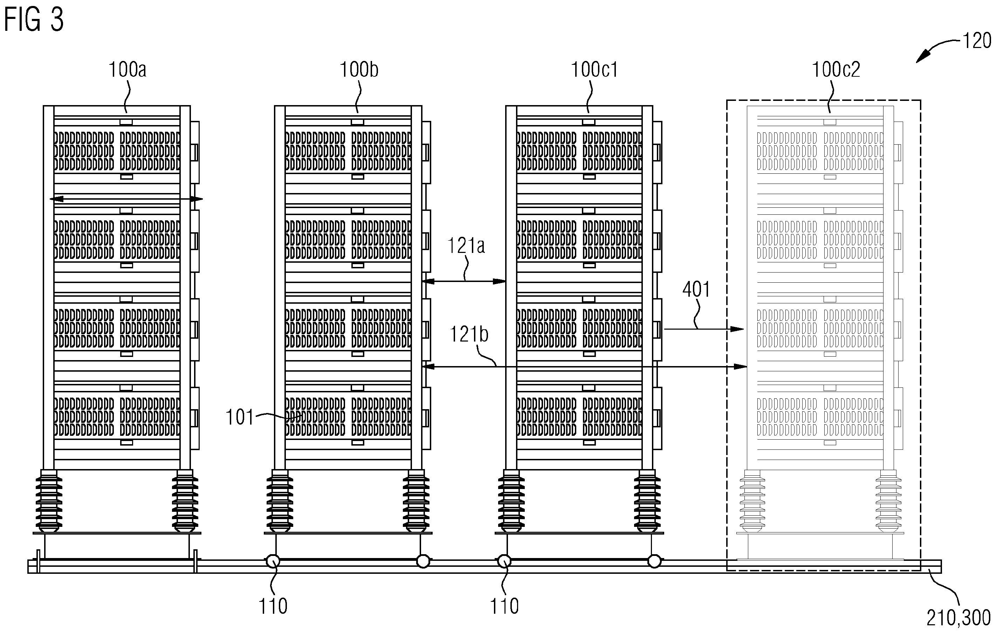

Figure 2 shows the two racks 100a, 100b is the second state. In the second state, the two racks 100a, 100b are positioned further apart from each other along the first direction 401 than in the first state. This is also explained again below in connection with Figure 3.

For inserting one or more of the converter modules 101 or for removing one or more of the converter modules 101, the two racks 100a, 100b are positioned in the second state. It is possible to move the two racks 100a, 100b into the second state due to the respective displacement devices 110.

In the second state, the two sides 105a, 105b of the frames 102a, 102b facing each other have a distance 121 between them. The sides 105a, 105b extend each along the second direction 402. For example, along the first direction 401, the side 105a of the first frame 102a is a front side and the side 105b of the second frame 102b is a rear side.

For example, the size of the distance 121 results from an extension 103 of the converter module 101 along the first direction 401 plus a desired and/or preset clearance 104. Therefore, the distance 121 is large enough to move the converter module 101 in a space 108 between the two racks 100a, 100b, in particular without significant risk of damage due to collision with the racks 100a, 100b.

After maintenance or replacement of the converter module 101, it is possible to move the two racks 100a, 100b towards each other in order to reduce the distance 121. During the first state, the distance 121 is smaller than in the second state. In the first state, the distance 121 is smaller than the extension 103, for example. The distance 121 can be so small in the first state because the converter module 101 is not replaced and therefore no converter module 101 has to be moved in the space 108. If a replacement is to take place, the two racks 100a, 100b are first moved away from each other in order to increase the distance 121 again and create sufficient free volume in space 108.

For example, the extension 103 is 1300 mm. Other extensions 103 are possible, of course. The distance 121 is less than 1300 mm in the first state, for example. The clearance 104 is in a range of between 200 mm to 300 mm, for example. Other clearances 104 are possible, of course. The distance 121 is more than 1500 mm to 1600 mm in the second state, for example.

For example, rails 210 are installed on the floor 300. The rails 210 are attached to the floor 300. The rails 210 interact with the displacement device 110 to enable movement along the first direction 401. The rails 210 are elongated along the first direction 410. The rails 210 extend along the first direction. For example, the two racks 100a, 100b are held and guided together on the same rails 210.

Figure 3 schematically shows the rack system 120 with three racks 100a, 100b, 100c. The rack system 120 according to Figure 3 functions substantially as explained in relation to Figures 1 and 2.

For a replacement of one of the converter modules 101 of the second rack 100b, the third rack 100c is moved away from the second rack 110b along the first direction 401. In the first state the third rack 100c is located with a minimum distance 121a near the second rack 100b as indicated with reference numeral 100c1. In the second state the third rack 100c is located with a larger distance 121b further away from the second rack 100b as indicated with reference numeral 100c2.

For example, the minimum distance 121a defined so that sufficient electrical insulation between the racks 110b, 100c is possible and short circuits or voltage jumps are avoided.

For example, the minimum distance 121a is prescribed by law or specified in operating standards or similar.

For example, the first rack 100a of the rack system 120 does not comprise a displacement device 110 and/or is secured fixedly and immovable to the floor 300. This is possible because there is no further rack behind the first rack 110a and therefore there is no need to move the first rack 100a to make room for a converter module to be replaced. The second rack 100b and the third rack 100c are movable relative to the floor 300. According to further examples, all racks 100 of the rack system 120 are movable along the first direction 401 relative to the floor 300.

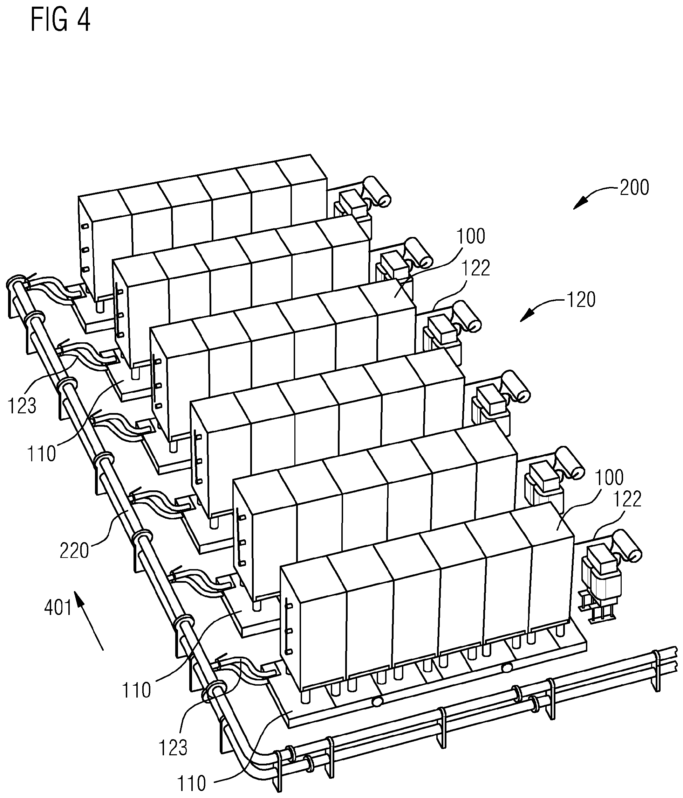

Figure 4 schematically shows a power converter system 200 with a plurality of racks 100 with respective converter modules 101. In a first state, the racks 100 are positioned near each other to safe installation space. In a second state, the distance 121 between two directly adjacent racks 100 is increased compared to the first state to provide enough space 108 for installation or maintenance.

Each rack 100 with respective converter modules 101 is connected to an electricity supply 122 during the first state. For example, the connection to the electricity supply 122 is disconnected before moving the rack 100 into the second state. For example, a plug is used for connection and disconnection. It is possible, that the connection to the electricity supply 122 is provided such that movement into the second state is possible without disconnection, for example with a flexible cable that is long enough. For example, a cable guard or a cable chain is used for the electrical connection.

Each rack 100 with respective converter modules 101 is connected to a coolant supply 123 for cooling the racks 100 during the first state. For example, each rack 100 with respective converter modules 101 is connected to a manifold 220 for the coolant during the first state.

For example, the connection to the coolant supply 123 is disconnected before moving the rack 100 into the second state. It is possible, that the connection to the coolant supply 123 is provided such that movement into the second state is possible without disconnection, for example with a flexible hose that is long enough.

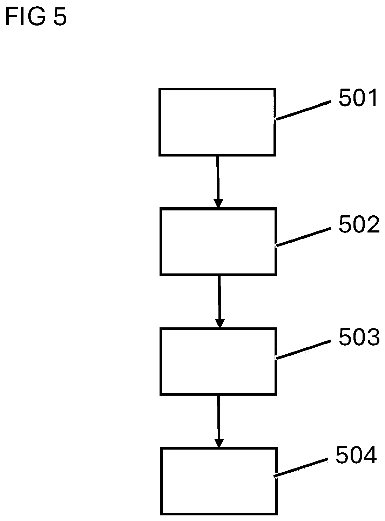

Figure 5 shows a flowchart of a method for operating the rack system 120 of the power converter system 200 according to an embodiment.

In an initial state, for example, the rack system 120 is in the first state in which converter operation takes place.

For a replacement of one of the converter modules 101, in a step 501, the rack 100 in front of the rack 100 of this converter module 101 is shifted along the first direction 401 away from the rack 100 of this converter module 101.

For example, the connection to the electricity supply 122 and/or the connection to the coolant supply 123 of the rack 100 in front are disconnected before shifting this rack 100.

For example, a blocking of the rack 100 in front is released before shifting this rack 100 to enable the movement.

In a step 502, the converter module 101 is moved out of the rack 100 along the first direction between the rack 100 and the rack 100 in front.

In a step 503, another converter module 101 is moved into the rack 100 along the first direction between the rack 100 and the rack 100 in front.

In a step 504, the rack 100 in front is moved towards the rack 100 in which the module was replaced, towards its initial position for converter operation to take place.

For example, the blocking of the rack 100 in front is actuated after shifting this rack 100 to its operational position in the first state to block movement along the first direction 401.

The power converter system 200 with the rack system 120 enables to place several racks 100 with respective converter modules 101 as close to each other as electrical insulation allows in the first state. The racks 100 comprise each the displacement device 110 are based on the rail 210, for example, which enables ease moving into and out of the second state. In case of maintenance, the racks 100 can be moved one by one to make space to access the individual rack 100. Thus, a reduced footprint of the power converter system 200 is possible without the need of shrinking the converter modulus 101.

### Reference Signs

100 rack
101 converter module
102 frame
103 extension
104 clearance
105 side
106 insulator
107 base plate
108 space
110 displacement device
120 rack system
121 distance
122 electricity supply
123 coolant supply
200 power converter system
210 rail
220 manifold
300 floor
401 first direction
402 second direction
403 third direction
501-504 method steps

## Claims

1. A rack for a power converter system (200), the rack (100) comprising:
- a frame (102) for holding a plurality of converter modules (101),
- a displacement device (110) for moving the rack (100) relative to a floor (300) on which the rack (100) is supported.

2. The rack according to the preceding claim, wherein the displacement device (110) comprises a first state in which the movement relative to the floor (300) is blocked and a second state in which the movement relative to the floor (300) is enabled.

3. The rack according to any one of the preceding claims, wherein the displacement device (110) comprises wheels.

4. The rack according to the preceding claim, wherein the wheels are configured to run on rails (210).

5. The rack according to any one of the preceding claims, wherein the frame (102) is configured so that the converter modules (101) are insertable and removable along a first direction (401), wherein the displacement device (110) is configured for moving the rack (100) along the first direction (401).

6. A rack system for a power converter system (200), the rack system comprising:
- a first rack (100) according to any one of the preceding claims,
- a second rack (100) according to any one of the preceding claims, wherein the first rack (100) and the second rack (100) are arranged next to each other along a first direction (401) and are movable relative to each other along the first direction (401).

7. The rack system according to claim 6, wherein in a first state a distance (121) between the first rack (100) and the second rack (100) is less than an extension (103) of the converter module (101) along the first direction (401), and in a second state the distance (121) is greater than the extension (103).

8. The rack system according to claim 6 or claim 7, comprising rails (210), wherein the frames (100) are each movably supported on the rails (210) for a movement along the rails (210).

9. The rack system according to any one of claims 6 to 8, comprising an electricity supply (122), wherein the first rack (100) and the second rack (100) are each releasably connected to the electricity supply (122).

10. The rack system according to any one of claims 6 to 8, comprising an electricity supply (122), the electricity supply (122) comprising a flexible cable connection to the first rack (100) and the second rack (100), wherein the flexible cable connection is configured to enable the movement of the first rack (100) and the second rack (100) relative to each other.

11. The rack system according to any of claims 6 to 10, comprising a coolant supply (123), wherein the first rack (100) and the second rack (100) are each releasably connected to the coolant supply (123).

12. The rack system according to any of claims 6 to 10, comprising a coolant supply (123), the coolant supply (123) comprising a flexible hose connection to the first rack (100) and the second rack (100), wherein the flexible hose connection is configured to enable the movement of the first rack (100) and the second rack (100) relative to each other.

13. A method for operating a rack system (120) of a power converter system (200), the method comprising:
- moving a rack (100) of the power converter system (200) relative to a floor (300) along a first direction (401) from a first state to a second state,
- inserting and/or removing a converter module (101) along the first direction (401) into and/or out of the rack (100),
- moving the rack (100) along the first direction (401) from the second state to the first state.

14. The method according to claim 13, comprising:
- blocking a movement of the rack (100) in the first state,
- releasing the blocking before moving the rack (100) to the second state.

15. The method according to claims 13 or 14, wherein the rack system comprises a second rack (100), the method comprising:
- moving the first rack (100) and the second rack (100) relative to each other along the first direction (401) from the first state to the second state.
